# EUROPEAN PATENT APPLICATION

(11) **EP 4 570 707 A1**
(43) Date of publication of application: **18.06.2025**
(21) Application number: 23852161.1
(22) Date of filing: 27.03.2023
(51) Int. Cl.: B65G 1/04

(54) **OVERHEAD CONVEYING VEHICLE**

(30) Priority: 09.08.2022 JP 2022126974
(71) Applicant: Murata Machinery, Ltd., Kyoto-shi, Kyoto 601-8326 (JP)
(72) Inventor: KOBAYASHI, Makoto, Ise-shi, Mie 516-0003 (JP)
(74) Representative: Weickmann & Weickmann PartmbB
(86) International application number: PCT/JP2023/012190
(87) International publication number: WO 2024/034175

(57) **Abstract**

An overhead transport vehicle includes: a transfer section configured to transfer an article to and from a load port included in equipment; a plurality of sensors configured to emit detection waves downwardly to detect presence or absence of an obstacle, the sensors having different detection ranges from each other; and a control section configured to control the overhead transport vehicle. The transfer section includes a gripping section, a rotating section, and a lifting section. The control section, during transferring of the article by the transfer section, controls the rotating section in accordance with a direction of accessing onto the load port such that the article is transferred in a specified direction and does not perform detection processing of one or more sensors, among the plurality of sensors, having detection ranges in which the equipment is included.

## Description

### Technical Field

One aspect of the present invention relates to an overhead transport vehicle.

### Background Art

As technology related to overhead transport vehicles, for example, Patent Literature 1 describes overhead traveling transport equipment including a track installed on a ceiling and a cart with hoist (overhead transport vehicle) traveling along the track. In the overhead traveling transport equipment described in Patent Literature 1, a traveling cart with hoist is stopped above a load port of manufacturing equipment, and a hand is lowered by winding down a hand suspension section to hold an article by the hand. On the hoist side of the cart, an obstacle detection sensor (sensor) is provided detecting the presence or absence of an obstacle by performing optical search for a lifting path between the cart with hoist and the load port.

### Citation List

### Patent Literature

[Patent Literature 1] Japanese Patent No. 3371897

### Summary of Invention

### Technical Problem

The article has a lid on its side surface in one direction, and a load port needs to receive the article such that the lid is in a particular direction with respect to the load port itself. In other words, the above-described technology may restrict a direction of accessing of the overhead transport vehicle onto the load port in order to match an orientation of the article to be transferred to and from the load port to a specified orientation. Specifically, in order to satisfy the above-described condition, only a track extending in a left-right direction of the load port can be provided. Furthermore, in this case, since the orientation of the overhead transport vehicle with respect to the load port is always the same, a sensor for securing safety around the load port detects only a defined area in one direction. In light of the above, the above-described technology may have a low degree of freedom in layout of the track, resulting in a track where overhead transport vehicles make a detour to access the load port, and thus the conveyance efficiency may decrease.

Therefore, an object of one aspect of the present invention is to provide an overhead transport vehicle capable of increasing the degree of freedom in layout of the track and improving conveyance efficiency.

### Solution to Problem

An overhead transport vehicle according to one aspect of the present invention is an overhead transport vehicle configured to travel along a track and transport an article, the overhead transport vehicle including: a transfer section configured to transfer the article to and from a load port included in equipment; a plurality of sensors configured to emit detection waves downwardly during transferring of the article by the transfer section to detect presence or absence of an obstacle, the sensors having different detection ranges from each other; and a control section configured to control the overhead transport vehicle, in which the transfer section includes a gripping section configured to grip the article, a rotating section configured to rotate the gripping section around a rotation axis along a vertical direction as a basic axis, and a lifting section configured to raise and lower the gripping section, and the control section, during transferring of the article by the transfer section, controls the rotating section in accordance with a direction of accessing onto the load port such that the article is transferred in a specified direction and does not perform detection processing of one or more sensors, among the plurality of sensors, having detection ranges in which the equipment is included according to a positional relationship with respect to the load port.

The overhead transport vehicle allows, during transferring an article, the article to rotate so as to be transferred with an orientation specified for the load port. At that time, since the detection processing of one or more sensors having the detection ranges in which the equipment is included is not performed, the equipment is not falsely detected as an obstacle by the sensors. Therefore, regardless of the direction in which the overhead transport vehicle accesses the load port, the article can be transferred between the overhead transport vehicle and the load port with the orientation specified for the load port while safety around the load port is secured with the sensors. For example, a track with which the overhead transport vehicle makes a detour to access the load port is not required, the degree of freedom in layout of the track can increase, and the conveyance efficiency can improve.

In the overhead transport vehicle according to one aspect of the present invention, the lifting section may raise and lower the rotating section together with the gripping section, and the rotating section may rotate only the gripping section. In this case, rotation to change the orientation of the article during transferring can be achieved with a small mechanism.

In the overhead transport vehicle according to one aspect of the present invention, the rotating section may rotate the gripping section so that a rotation position around the rotation axis of the gripping section switches between at least a first position, a second position that differs by +90° from the first position, and a third position that differs by -90° from the first position. In this case, an apparatus (encoder or the like) to adjust an angle of rotation by the rotating section is not required.

In the overhead transport vehicle according to one aspect of the present invention, the sensor may have a detection range in at least three directions in plan view including forwards, backwards, and in one sideways direction of an advance direction of the overhead transport vehicle. Consequently, even if the overhead transport vehicle accesses the load port from three directions, by using any of the sensors installed in the three directions as appropriate in accordance with an access direction onto the load port, the presence or absence of an obstacle can be detected. In addition, the presence or absence of an obstacle can be detected with a reduced number of sensors used.

In the overhead transport vehicle according to one aspect of the present invention, the transfer section may include an adjusting section configured to rotate the lifting section together with the gripping section and the rotating section around the rotation axis as a basic axis and to adjust a rotation position around the rotation axis of the gripping section, the rotating section, and the lifting section. In this case, the article can be rotated in two stages, specifically, at the adjusting section and the rotating section.

In the overhead transport vehicle according to one aspect of the present invention, the control section may pre-store sensor-for-use information in which a rotation position around the rotation axis of the gripping section is associated with one or more sensors to be used among the plurality of sensors, and may determine, during transferring of the article by the transfer section, one or more sensors that will not perform the detection processing based on the sensor-for-use information and the rotation position around the rotation axis of the gripping section. In this case, the pre-stored sensor-for-use information can be used for avoiding performing the detection processing of one or more sensors having the detection ranges in which the equipment is included.

In the overhead transport vehicle according to one aspect of the present invention, the overhead transport vehicle may travel along a track, and the track may include a transit track passing over the equipment and passing over the load port included in the equipment along a front-rear direction of the load port. The track thus including the transit track allows the conveyance efficiency to improve compared to the case of including a track that detours to access the load port.

In the overhead transport vehicle according to one aspect of the present invention, the control section may perform control not to emit a detection wave when not performing the detection processing of one or more sensors, among the plurality of sensors, having the detection ranges in which the equipment is included. The detection processing may be disabled by turning off the sensor. In this case, no extra power is used.

In the overhead transport vehicle according to one aspect of the present invention, the control section, in a case of transferring the article from the load port to the gripping section, may control the rotating section to bring the article gripped in a specified orientation with respect to the gripping section. In this case, the overhead transport vehicles can always grip the article in a constant direction, which facilitates adjustment of subsequent rotations. In addition, the center of gravity is always constant, which reduces the load on the traveling for the overhead transport vehicle.

### Advantageous Effects of Invention

According to one aspect of the invention, it is possible to provide an overhead transport vehicle capable of increasing the degree of freedom in layout of the track and improving conveyance efficiency.

### Brief Description of Drawings

[FIG. 1] FIG. 1 is a schematic side view illustrating an overhead transport vehicle according to an embodiment.
[FIG. 2] FIG. 2 is a plan view illustrating an example track layout.
[FIG. 3] FIG. 3 is a view illustrating an example of transferring an article from a load port to an overhead transport vehicle.
[FIG. 4] FIG. 4 is a view illustrating another example of transferring the article from the load port to an overhead transport vehicle.
[FIG. 5] FIG. 5 is a view illustrating another example of transferring the article from the load port to the overhead transport vehicle.
[FIG. 6] FIG. 6(a) is a view illustrating a detection range of a second sensor according to a modification. FIG. 6(b) is a view illustrating a detection range of a second sensor according to another modification.

### Description of Embodiments

One embodiment will now be described in detail with reference to the attached drawings. Identical or equivalent elements will be marked with the same symbol, and redundant explanations will be omitted.

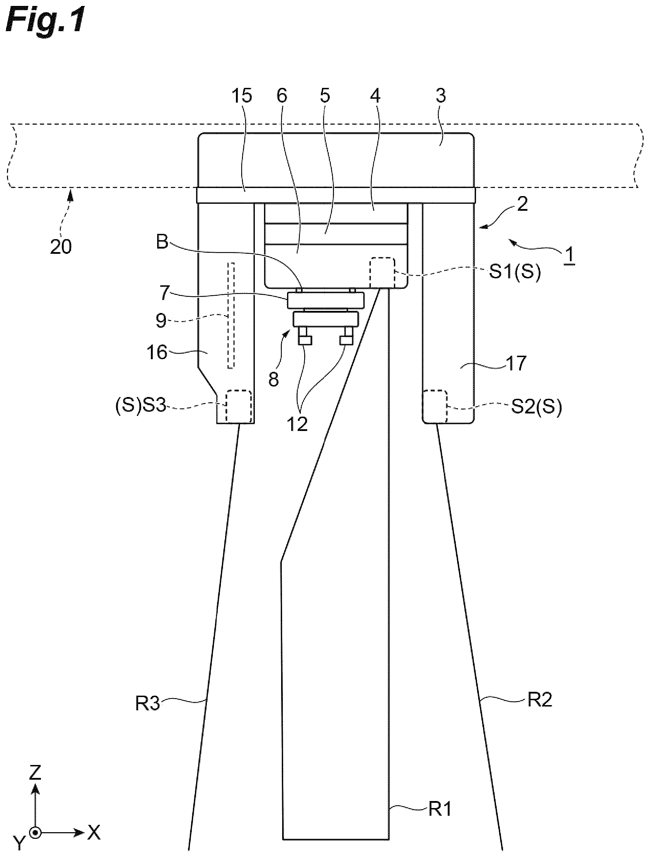

As illustrated in FIGS. 1, 2, and 3, the overhead transport vehicle 1 travels along tracks 20 laid near a ceiling of a clean room where semiconductor devices are manufactured, for example. The overhead transport vehicle 1 transports an article 100. The article 100 is, for example, a front opening unified pod (FOUP) configured to accommodate a plurality of semiconductor wafers, for example. In the drawings, an X direction corresponds to one horizontal direction, a Y direction corresponds to a horizontal direction perpendicular to the X direction, and a Z direction corresponds to a vertical direction.

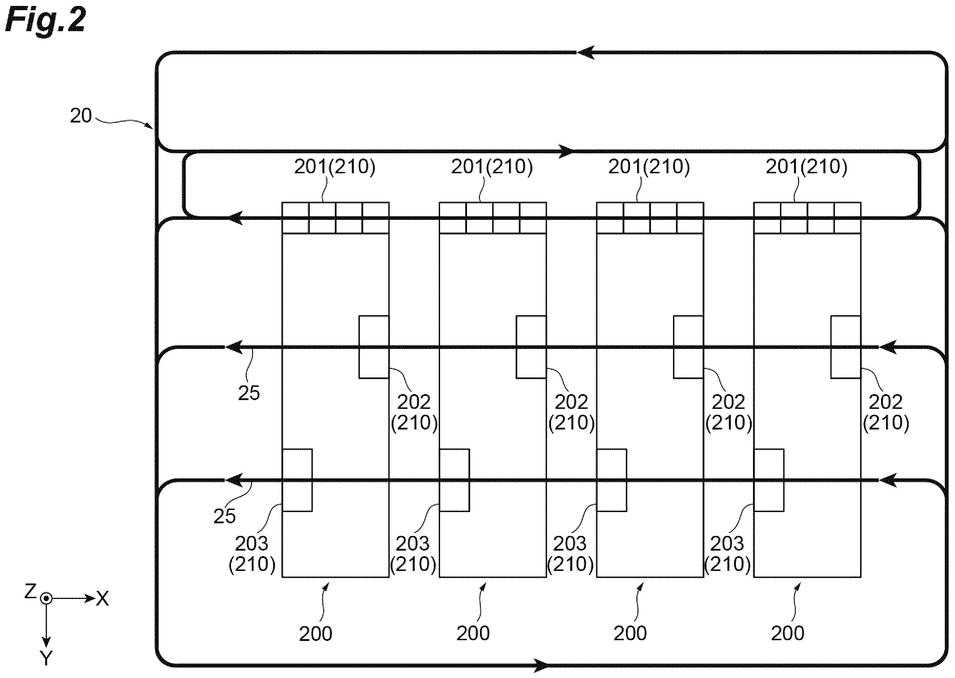

The overhead transport vehicle 1 transfers articles 100 to and from the load ports 210 included in a plurality of pieces of processing equipment (equipment) 200. Processing equipment 200 is, for example, equipment configured to apply various types of processing to semiconductor wafers. The plurality of pieces of processing equipment 200, in an example illustrated in FIG. 2, are disposed in the X direction at predetermined intervals in a clean room.

The track 20 is suspended from the ceiling, for example. The track 20 is a pre-defined one-way travel path on which the overhead transport vehicle 1 travels. The track 20 passes over a plurality of load ports 210. The track 20 includes a transit track 25. The transit track 25 is a track configured to pass over the processing equipment 200 and pass over the load port 210 included in the processing equipment 200, along the front-back direction of the load port 210.

The load port 210 is a loading platform in the processing equipment 200. On the load port 210, one or more articles 100 are placed. The load port 210 is disposed on a passage side (outer edge side) of the processing equipment 200 in plan view. The load port 210 has an orientation set thereto, and for example, the passage side of the load port 210 is forward (front side) orientation. The article 100 is transferred to the load port 210 in a specified orientation. For example, the article 100 is placed on the load port 210 so that the forward side (opposite the lid side) of the article 100 is oriented like the forward side of the load port 210.

The load port 210 includes a first load port 201, a second load port 202, and a third load port 203. The first load port 201 is a loading platform whose front-rear direction intersects with (is orthogonal to) a passage direction of the track 20. The second and the third load ports 202, 203 are loading platforms through which the transit track 25 passes along their front-rear directions. The second load port 202 has a direction oriented from the forward side to the backward side, the direction opposite to the passage direction of the transit track 25. The third load port 203 has a direction oriented from the backward side to the forward side, the direction corresponding to the passage direction of the transit track 25. The second and the third load ports 202, 203 are disposed to enter the processing equipment 200 in plan view. The second and the third load ports 202, 203 are disposed in a space open to a passage side and an upper side in the processing equipment 200.

The overhead transport vehicle 1 includes a frame unit 2, a traveling unit 3, a lateral unit 4, a theta unit (adjusting section) 5, a lifting drive unit (lifting section) 6, a rotating unit (rotating section) 7, a gripping unit (gripping section) 8, and a transport vehicle controller (control section) 9.

The frame unit 2 has a center frame 15, a front frame 16, and a rear frame 17. The front frame 16 extends downward from an end of the forward side (forward side in the advance direction of the overhead transport vehicle 1) in the center frame 15. The rear frame 17 extends downward from an end of the backward side (backward side in the advance direction of the overhead transport vehicle 1) in the center frame 15.

The traveling unit 3 is disposed on the upper side of the center frame 15. The traveling unit 3, for example, travels along the track 20 by receiving a non-contact supply of electric power from high-frequency current lines laid along the track 20. The lateral unit 4 is disposed below the center frame 15. The lateral unit 4 moves the theta unit 5, the lifting drive unit 6, the rotating unit 7, and the gripping unit 8 in the lateral direction (sideway in the advance direction of the overhead transport vehicle 1).

The theta unit 5 is disposed below the lateral unit 4. The theta unit 5 rotates the lifting drive unit 6 together with the gripping unit 8 and the rotating unit 7 around its central axis (rotation axis) as a basic axis along the Z direction, and adjusts the rotation position of the gripping unit 8, the rotating unit 7, and the lifting drive unit 6 around the central axis. The lifting drive unit 6 is disposed below the theta unit 5. The lifting drive unit 6 raises and lowers the rotating unit 7 together with the gripping unit 8. The lifting drive unit 6 raises and lowers by winding or unwinding the belt B connected to the rotating unit 7.

The rotating unit 7 is suspended from the lifting drive unit 6 by a plurality of the belts B. The rotating unit 7 rotates only the gripping unit 8 around the central axis (rotation axis) along the Z direction as a basic axis. The rotating unit 7 constitutes a swiveling mechanism in a slip-ring system. For example, the rotating unit 7 includes a slip ring disposed on the central axis and a motor disposed away from the central axis and connected to the slip ring by a gear. The rotating unit 7 rotates the gripping unit 8 to switch the rotation position of the gripping unit 8 around the central axis between at least a first position, which is the initial position, a second position that differs by +90° from the first position, and a third position that differs by -90° from the first position.

The gripping unit 8 is disposed below the rotating unit 7. The gripping unit 8 grips (holds) the article 100 in the specified orientation. The gripping unit 8 has a pair of grippers 12, 12. The pair of grippers 12, 12 are opened and closed by, for example, a drive motor and a link mechanism. The rotating unit 7 and the gripping unit 8 are raised and lowered by the winding or unwinding of the belt B by the lifting drive unit 6. The lateral unit 4, the theta unit 5, the lifting drive unit 6, the rotating unit 7, and the gripping unit 8 constitute the transfer section configured to transfer the article 100 to and from the load port 210. Hereinafter, the lateral unit 4, the theta unit 5, the lifting drive unit 6, the rotating unit 7, and the gripping unit 8 are also referred to simply as the "transfer section".

The transport vehicle controller 9 is disposed, for example, in the frame unit 2. The transport vehicle controller 9 is an electronic control unit including a central processing unit (CPU), read only memory (ROM) and random access memory (RAM), and the like. The transport vehicle controller 9 controls the components of the overhead transport vehicle 1.

Here, the overhead transport vehicle 1 in the present embodiment includes a plurality of sensors S. The sensor S detects the presence or absence of an obstacle by emitting directional detection waves downward during transferring of an article 100 by the transfer section (lateral unit 4, theta unit 5, lifting drive unit 6, rotating unit 7, and gripping unit 8). The sensor S is a so-called look-down sensor. The sensor S is not limited, but a laser rangefinder may be used, for example. The sensor S may be configured to emit other detection waves such as ultrasound.

For example, the sensor S emits a laser beam toward the vicinity of a descent point of the gripping unit 8 and receives the reflected light therefrom. The sensor S detects whether or not an obstacle exists in the vicinity of the load port 210 based on the reflected light of the received laser beam. For example, the sensor S detects whether or not an obstacle, such as a worker, exists on the front (aisle) side of the load port 210. The sensor S is connected to the transport vehicle controller 9. The plurality of sensors S include a first sensor S1, a second sensor S2, and a third sensor S3.

The first sensor S1 is installed on one sideway of the advance direction in the overhead transport vehicle 1 in plan view. The first sensor S1 is provided at the lower part of the lifting drive section 14. The first sensor S1 detects the presence or absence of obstacles within the detection range R1. The detection range R1 is a range starting from the first sensor S1 as a start point and extending downward two-dimensionally along the XZ plane. The detection range R1 is a range where the detection result of the first sensor S1 is valid. The range of the detection range R1 is along the XZ plane and may be inclined with respect to the XZ plane.

The second sensor S2 is installed behind the advance direction in the overhead transport vehicle 1 in plan view. The second sensor S2 is provided at the lower part of the rear frame 17. The detection range R2 is a range starting from the second sensor S2 as a start point and extending downward two-dimensionally along the YZ plane. The detection range R2 is a range where the detection result of the second sensor S2 is valid. The range of the detection range R2 is along the YZ plane and may be inclined with respect to the YZ plane.

The third sensor S3 is installed ahead in advance direction of the overhead transport vehicle 1 in plan view. The third sensor S3 is provided at the lower part of the front frame 16. The detection range R3 is a range starting from the third sensor S3 as a start point and extending downward two-dimensionally along the YZ plane. The detection range R3 is a range where the detection result of the third sensor S3 is valid. The range of the detection range R3 is along the YZ plane and may be inclined with respect to the YZ plane.

The transport vehicle controller 9 pre-stores map data regarding the position and the orientation, or the like of the plurality of load ports 210. The transport vehicle controller 9 acquires, when receiving, for example, a transport command to transport an article 100 from a host controller, port information about the position and a specified orientation of the load port 210 from and to which the article is to be transported, from the map data. The transport vehicle controller 9 controls the traveling unit 3 based on the port information and travels the overhead transport vehicle 1 to the position corresponding to the load port 210. The transport vehicle controller 9 then controls the transfer section to transfer the article 100 to or from the load port 210.

The transport vehicle controller 9 controls the rotating unit 7 so that the article 100 is transferred in the specified orientation during transferring of the article 100 by the transfer section. Specifically, when transferring an article 100 by the transfer section, the transport vehicle controller 9 controls the rotating unit 7 based on the port information to rotate the gripping unit 8 around the central axis thereof so that the orientation specified in the load port 210 match the orientation of the article 100 gripped by the gripping unit 8.

The transport vehicle controller 9 disables one or more sensors S, among the plurality of sensors S, having the detection ranges in which the processing equipment 200 is included during transferring of the article 100 by the transfer section. Specifically, the transport vehicle controller 9 pre-stores the sensor-for-use information in which the rotation position of the gripping unit 8 around the central axis is associated with one or more sensors used among the plurality of sensors S. Although the detection processing of all the sensors S is not performed during traveling, when an article 100 is transferred by the transfer section, the transport vehicle controller 9 executes the detection processing of the sensors S used based on the sensor-for-use information and the rotation position of the gripping unit 8 around the central axis. Executing the detection processing specifically means emitting a laser beam toward the vicinity of the descent point of the gripping unit 8 and receiving the reflected light therefrom. As described above, during transferring, the one or more sensors S having the detection ranges in which the processing equipment 200 is included do not perform the detection processing.

The sensor-for-use information here includes a first position, a second position, and a third position as rotation positions of the gripping unit 8, and any of the first to the third sensors S1 to S3, which are sensors S used, is associated with each of these rotation positions. For example, in the sensor-for-use information, the first sensor S1 is associated, as a sensor S used, with the first position where the rotation position of the gripping unit 8 is the initial position, the second sensor S2 is associated, as a sensor S used, with the second position where the rotation position of the gripping unit 8 is +90° from the first position, and the third sensor S3 is associated, as a sensor S used, with the third position where the rotation position of the gripping unit 8 is -90° from the first position.

The overhead transport vehicle 1 configured as described above operates, as an example, as described below.

### [Transfer between the first load port 201 and the overhead transport vehicle 1]

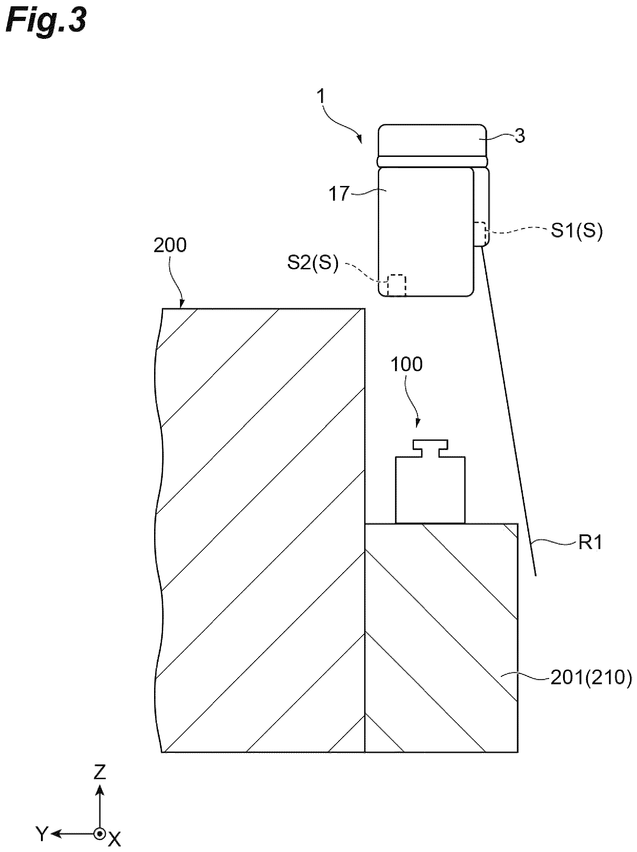

For example, as illustrated in FIG. 3, when an article 100 is transferred from the first load port 201 to the overhead transport vehicle 1, the overhead transport vehicle 1, which is not holding the article 100, first obtains port information regarding the position and the orientation of the first load port 201 from the map data. The overhead transport vehicle 1 travels based on the port information, and travels along the track 20 to a position corresponding to the first load port 201 to stop. Along with this, the overhead transport vehicle 1 rotates the rotating unit 7 to match the orientation of the article 100 to be transferred to the specified orientation based on the port information, to adjust the direction of the gripping unit 8. Note that, in a case of transferring to the first load port 201, the overhead transport vehicle 1 does not rotate the rotating unit 7 because transfer is possible with the rotation position of the gripping unit 8 around the central axis still being the first position, which is the initial position. At this time, however, in a case where the rotation position of the gripping unit 8 to be lowered deviates from the orientation of the first load port 201, the overhead transport vehicle 1 adjusts the horizontal position and the horizontal angle of each of the rotating unit 7 and the gripping unit 8 by driving the lateral unit 4 and the theta unit 5.

The overhead transport vehicle 1 in the present embodiment does not perform, during transferring of the article 100, the detection processing of one or more sensors S, among the plurality of sensors S, having the detection ranges in which the processing equipment 200 is included. Specifically, the overhead transport vehicle 1 refers to the sensor-for-use information, and based on the fact that the rotation position of the gripping unit 8 around the central axis is the first position, which is the initial position, determines to use the first sensor S1 and not to perform the detection processing of the second and the third sensors S2 and S3. The overhead transport vehicle 1 then detects the presence or absence of an obstacle around (in front of) the first load port 201 using only the first sensor S1. Subsequently, the overhead transport vehicle 1 lowers the rotating unit 7 and the gripping unit 8 by the lifting drive unit 6, and grips a flange of the article 100 placed on the first load port 201 with the gripping unit 8. The overhead transport vehicle 1 then raises the rotating unit 7 and the gripping unit 8 to the uppermost lifting position with the lifting drive unit 6, and then is ready to travel.

On the other hand, in the case of transferring the article 100 from the overhead transport vehicle 1 to the first load port 201, the overhead transport vehicle 1 holding the article 100 first obtains port information regarding the position and the orientation of the first load port 201 from the map data. The overhead transport vehicle 1 travels based on the port information, and travels along the track 20 to a position corresponding to the first load port 201 to stop. Along with this, the overhead transport vehicle 1 rotates the rotating unit 7 to match the orientation of the article 100 to be transferred to the specified orientation based on the port information, to adjust the direction of the gripping unit **8.** Here, the overhead transport vehicle 1 does not rotate the rotating unit because the transfer is possible with the rotation position of the gripping unit 8 around the central axis in the first position. At this time, however, in a case where the rotation position of the gripping unit 8 to be lowered deviates from the orientation of the first load port 201, the overhead transport vehicle 1 adjusts the horizontal position and the horizontal angle of each of the rotating unit 7 and the gripping unit 8 by driving the lateral unit 4 and the theta unit 5.

The overhead transport vehicle 1 in the present embodiment, during transferring of an article 100, does not perform the detection processing of one or more sensors S, among the plurality of sensors S, having the detection ranges in which the processing equipment 200 is included. Specifically, the overhead transport vehicle 1 refers to the sensor-for-use information and decides to use the first sensor S1 and not to perform the detection processing of the second and third sensors S2 and S3 based on the fact that the rotation position of the gripping unit 8 around the central axis is the first position. The overhead transport vehicle 1 then detects the presence or absence of an obstacle around (in front of) the first load port 201 using only the first sensor S1. The overhead transport vehicle 1 then lowers the rotating unit 7 and the gripping unit 8 by the lifting drive unit 6, places the article 100 on the first load port 201, and releases the gripping of the flange by the gripping unit 8. The overhead transport vehicle 1 then raises the rotating unit 7 and the gripping unit 8 to the uppermost lifting position with the lifting drive unit 6, and then is ready to travel.

[Transfer between the second load port 202 and the overhead transport vehicle 1]

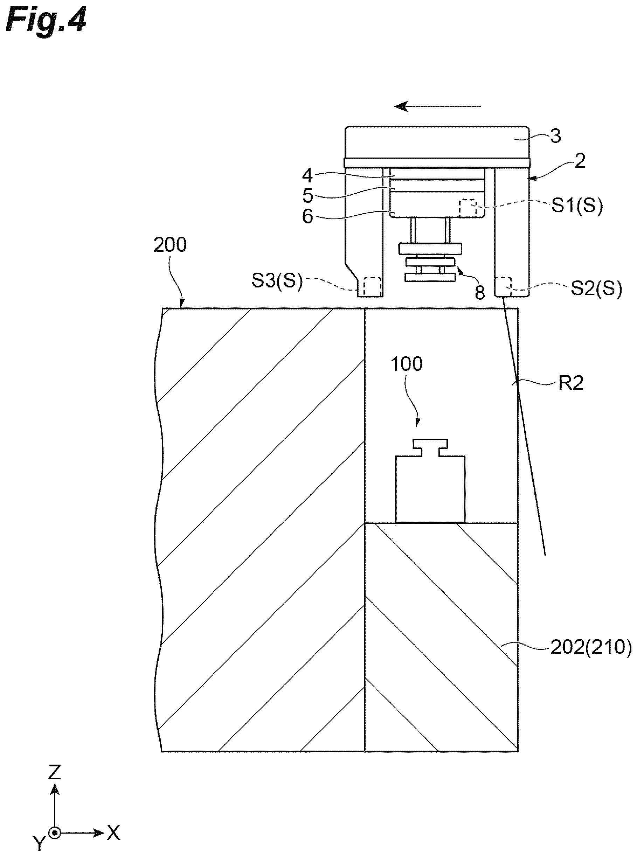

For example, as illustrated in FIG. 4, in a case of transferring an article 100 from the second load port 202 to the overhead transport vehicle 1, the overhead transport vehicle 1, which is not holding the article 100, first obtains port information regarding the position and the orientation of the second load port 202 from the map data. The overhead transport vehicle 1 travels based on the port information and travels along the track 20 to a position corresponding to the second load port 202 to stop. Along with this, the overhead transport vehicle 1 rotates the rotating unit 7 to match the orientation of the article 100 to be transferred to the specified orientation based on the port information, to adjust the direction of the gripping unit 8. Here, the overhead transport vehicle 1 controls the rotating unit 7 to set the rotation position of the gripping unit 8 around the central axis to the second position that differs by +90° from the first position, so that the article 100 is gripped in the specified orientation with respect to the gripping unit 8. At that time, in the case where the rotation position of the gripping unit 8 to be lowered deviates from the orientation of the second load port 202, the overhead transport vehicle 1 adjusts the horizontal position and the horizontal angle of each of the rotating unit 7 and the gripping unit 8 by driving the lateral unit 4 and the theta unit 5.

The overhead transport vehicle 1 in the present embodiment, during transferring of an article 100, does not perform the detection processing of one or more sensors S, among the plurality of sensors S, having the detection ranges in which the processing equipment 200 is included. Specifically, the overhead transport vehicle 1 refers to the sensor-for-use information, and based on the fact that the rotation position of the gripping unit 8 around the central axis is the second position, determines to use the second sensor S2 and not to perform the detection processing of the first and the third sensors S1 and S3. The overhead transport vehicle 1 then detects the presence or absence of an obstacle around (in front of) the second load port 202 using only the second sensor S2, and stops outputting detection waves from the first and the third sensors S1 and S3. Subsequently, the overhead transport vehicle 1 then lowers the rotating unit 7 and the gripping unit 8 by the lifting drive unit 6, and grips the flange of the article 100 placed on the second load port 202 with the gripping unit 8. The overhead transport vehicle 1 then raises the rotating unit 7 and the gripping unit 8 to the uppermost position by the lifting drive unit 6, and then rotates the rotating unit 7 so that the rotation position of the gripping unit 8 returns to the first position, which is the initial position. After the rotation position of the gripping unit 8 returns to the initial position, the overhead transport vehicle 1 can travel.

On the other hand, in the case of transferring the article 100 from the overhead transport vehicle 1 to the second load port 202, the overhead transport vehicle 1 holding the article 100 first obtains port information regarding the position and the orientation of the second load port 202 from the map data. The overhead transport vehicle 1 travels based on the port information and travels along the track 20 to a position corresponding to the second load port 202 to stop. Along with this, the overhead transport vehicle 1 rotates the rotating unit 7 so that the orientation of the article 100 to be transferred matches the specified orientation based on the port information. Here, the overhead transport vehicle 1 controls the rotating unit 7 to set the rotation position of the gripping unit 8 around the central axis to the second position, so that the article 100 is placed in the specified orientation with respect to the second load port 202. At that time, in the case where the rotation position of the gripping unit 8 to be lowered deviates from the orientation of the second load port 202, the overhead transport vehicle 1 adjusts the horizontal position and the horizontal angle of each of the rotating unit 7 and the gripping unit 8 by driving the lateral unit 4 and the theta unit 5.

The overhead transport vehicle 1 in the present embodiment does not perform, during transferring of the article 100, the detection processing of one or more sensors S, among the plurality of sensors S, having the detection ranges in which the processing equipment 200 is included. Specifically, the overhead transport vehicle 1 refers to the sensor-for-use information, and based on the fact that the rotation position of the gripping unit 8 around the central axis is the second position, determines to use the second sensor S2 and not to perform the detection processing of the first and the third sensors S1 and S3. The overhead transport vehicle 1 then detects the presence or absence of an obstacle around (in front of) the second load port 202 using only the second sensor S2. Subsequently, the overhead transport vehicle 1 lowers the rotating unit 7 and the gripping unit 8 by the lifting drive unit 6, places the article 100 on the second load port 202, and releases the gripping of the flange by the gripping unit 8. The overhead transport vehicle 1 then raises the rotating unit 7 and the gripping unit 8 to the uppermost position by the lifting drive unit 6, and then rotates the rotating unit 7 so that the rotation position of the gripping unit 8 returns to the first position, which is the initial position. After the rotation position of the gripping unit 8 returns to the initial position, the overhead transport vehicle 1 can travel.

### [Transfer between the third load port 203 and the overhead transport vehicle 1]

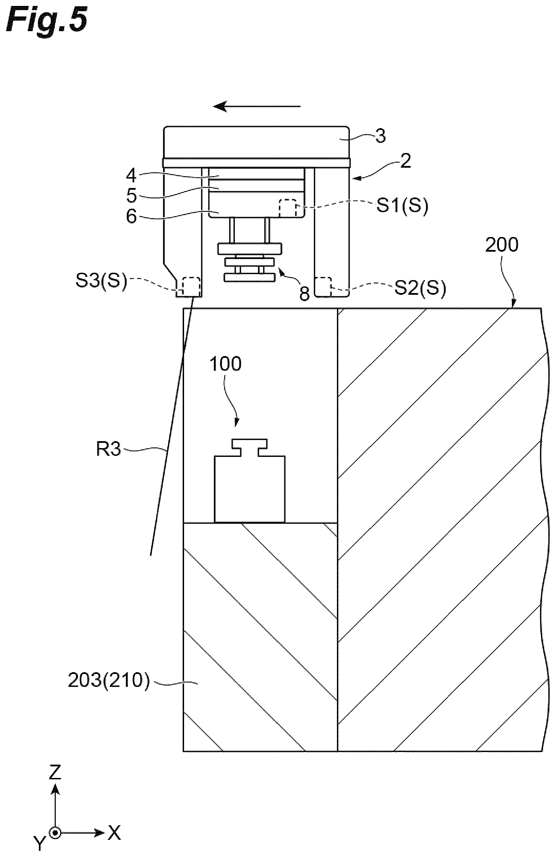

For example, as illustrated in FIG. 5, when the article 100 is transferred from the third load port 203 to the overhead transport vehicle 1, the overhead transport vehicle 1, which is not holding the article 100, first obtains port information regarding the position and the orientation of the third load port 203 from the map data. The overhead transport vehicle 1 travels based on the port information, and travels along the track 20 to a position corresponding to the third load port 203 to stop. Along with this, the overhead transport vehicle 1 rotates the rotating unit 7 to match the orientation of the article 100 to be transferred to the specified orientation based on the port information, to adjust the direction of the gripping unit 8. Here, the overhead transport vehicle 1 controls the rotating unit 7 to set the rotation position of the gripping unit 8 around the central axis to the third position that differs by -90° from the first position, so that the article 100 is gripped in the specified orientation with respect to the gripping unit 8. At that time, in the case where the rotation position of the gripping unit 8 to be lowered deviates from the orientation of the third load port 203, the overhead transport vehicle 1 adjusts the horizontal position and the horizontal angle of the rotating unit 7 and the gripping unit 8 by driving the lateral unit 4 and the theta unit 5.

The overhead transport vehicle 1 in the present embodiment does not perform, during transferring of the article 100, the detection processing of one or more sensors S, among the plurality of sensors S, having the detection ranges in which the processing equipment 200 is included. Specifically, the overhead transport vehicle 1 refers to the sensor-for-use information, and based on the fact that the rotation position of the gripping unit 8 around the central axis is the third position, determines to use the third sensor S3 and not to perform the detection processing of the first and the second sensors S1 and S2. The overhead transport vehicle 1 then detects the presence or absence of an obstacle around (in front of) the third load port 203 using only the third sensor S3. Subsequently, the overhead transport vehicle 1 lowers the rotating unit 7 and the gripping unit 8 by the lifting drive unit 6, and grips the flange of the article 100 placed on the third load port 203 with the gripping unit 8. The overhead transport vehicle 1 then raises the rotating unit 7 and the gripping unit 8 to the uppermost position by the lifting drive unit 6, and then rotates the rotating unit 7 so that the rotation position of the gripping unit 8 returns to the first position, which is the initial position. After the rotation position of the gripping unit 8 returns to the initial position, the overhead transport vehicle 1 can travel.

On the other hand, in the case where the article 100 is transferred from the overhead transport vehicle 1 to the third load port 203, the overhead transport vehicle 1 holding the article 100 first obtains port information regarding the position and the orientation of the third load port 203 from the map data. The overhead transport vehicle 1 travels based on the port information, and travels along the track 20 to a position corresponding to the third load port 203 to stop. Along with this, the overhead transport vehicle 1 rotates the rotating unit 7 to match the orientation of the article 100 to be transferred to the specified orientation based on the port information, to adjust the direction of the gripping unit 8. Here, the overhead transport vehicle 1 controls the rotating unit 7 to set the rotation position of the gripping unit 8 around the central axis to the third position, so that the article 100 is placed in the specified orientation with respect to the third load port 203. At that time, in the case where the rotation position of the gripping unit 8 to be lowered deviates from the orientation of the third load port 203, the overhead transport vehicle 1 adjusts the horizontal position and the horizontal angle of the rotating unit 7 and the gripping unit 8 by driving the lateral unit 4 and the theta unit 5.

In particular, the overhead transport vehicle 1 in the present embodiment, during transferring of the article 100, does not perform the detection processing of one or more sensors S, among the plurality of sensors S, having the detection ranges in which the processing equipment 200 is included. Specifically, the overhead transport vehicle 1 refers to the sensor-for-use information, and based on the fact that the rotation position of the gripping unit 8 around the central axis is the third position, determines to use the third sensor S3 and not to perform the detection processing of the first and the second sensors S1 and S2. The overhead transport vehicle 1 then detects the presence or absence of an obstacle around (in front of) the third load port 203 using only the third sensor S3. Subsequently, the overhead transport vehicle 1 then lowers the rotating unit 7 and the gripping unit 8 by the lifting drive unit 6, places the article 100 on the third load port 203, and releases the gripping of the flange by the gripping unit **8.** The overhead transport vehicle 1 then raises the rotating unit 7 and the gripping unit 8 to the uppermost position by the lifting drive unit 6, and then rotates the rotating unit 7 so that the rotation position of the gripping unit 8 returns to the first position, which is the initial position. After the rotation position of the gripping unit 8 returns to the initial position, the overhead transport vehicle 1 can travel.

As described above, the overhead transport vehicle 1 can rotate the article 100 so that the article 100 is transferred in the specified orientation during transferring of the article 100. At that time, since the detection processing of one or more sensors S having the detection ranges in which the processing equipment 200 is included is not performed, the processing equipment 200 is not falsely detected as an obstacle by the sensors S. Therefore, regardless of the direction in which the overhead transport vehicle 1 accesses the load port 210, it is possible to transfer the article 100 between the overhead transport vehicle 1 and the load port 210 with the orientation of the article 100 aligned to the specified orientation while ensuring safety around the load port 210 by the sensor S.

Therefore, for example, in the case of detecting the presence or absence of an obstacle by a sensor S having a detection range in one direction, depending on the direction in which the overhead transport vehicle 1 accesses the load port 210, there is a possibility that the processing equipment 200 is included in the detection range of the sensor S and an obstacle is detected erroneously. However, the overhead transport vehicle 1 can avoid such false detection, and there are no layout restrictions on the track 20. In addition, for example, there is a case where the direction in which the overhead transport vehicle 1 accesses the load port 210 is fixed because the orientation of the article 100 during transferring of the article 100 is aligned with the specified orientation. However, with the overhead transport vehicle 1, there are no such layout restrictions on the track 20. Therefore, according to the overhead transport vehicle 1, the track 20 with which the overhead transport vehicle 1 makes a detour to access the load port 210 is not required, for example, the degree of freedom in layout of the track 20 can increase, and the conveyance efficiency can improve.

In the overhead transport vehicle 1, the lifting drive unit 6 raises and lowers the rotating unit 7 together with the gripping unit 8, while the rotating unit 7 rotates only the gripping unit 8. In this case, rotation to change the orientation of the article 100 during transferring can be achieved with a small mechanism.

In the overhead transport vehicle 1, the rotating unit 7 rotates the gripping unit 8 to change the rotation position of the gripping unit 8 around the central axis between the first position, the second position that differs by +90° from the first position, and the third position that differs by -90° from the first position. In this case, an apparatus (encoder or the like) to adjust the angle of rotation by the rotating unit 7 is not required.

In the overhead transport vehicle 1, the sensor S includes the first to the third sensors S1 to S3 with detection ranges in three directions in plan view including forwards, backwards, and in one sideways direction of the advance direction of the overhead transport vehicle 1. Consequently, even if the overhead transport vehicle 1 accesses the load port 210 from three directions, the presence or absence of an obstacle can be detected by using any of the first to the third sensors S1 to S3, which have detection ranges in these three directions, as appropriate in accordance with the access direction onto the load port 210. In addition, the presence or absence of an obstacle can be detected with a reduced number of the sensors S used.

In the overhead transport vehicle 1, the transfer section includes a theta unit 5 configured to adjust the rotation position around the rotation axis of the gripping unit 8, the rotating unit 7, and the lifting drive unit 6. In this case, the article 100 can be rotated in two stages with the theta unit 5 and the rotating unit 7.

In the overhead transport vehicle 1, the transport vehicle controller 9 determines one or more sensors S that will not perform the detection processing based on the sensor-for-use information and the rotation position of the gripping unit 8 around the central axis during transferring of the article 100 by the transfer section. In this case, using the pre-stored sensor-for-use information can be used for avoiding performing the detection processing of one or more sensors S having the detection ranges in which the processing equipment 200 is included.

In the overhead transport vehicle 1, the track 20 includes the transit track 25 configured to pass over the processing equipment 200 and pass over first and second load ports 201, 202 included in the processing equipment 200, along the front-back direction of the first and the second load ports 201, 202. The track 20 thus including the transit track 25 allows the conveyance efficiency to improve compared to the case of including a track that detours to access the first and the second load ports 201, 202.

In the overhead transport vehicle 1, the transport vehicle controller 9 performs control not to emit a detection wave when not performing the detection processing of one or more sensors S, among the plurality of sensors S1 to S3, where the processing equipment 200 is included in their detection ranges. In this case, unnecessary detection waves are not emitted, and processing savings can be achieved. Note that the aspect in which the detection processing of the sensor S is avoided is not particularly limited to not emitting detection waves, but may include, for example, shutting down the sensor S (turning off the power), processing the detection results of the sensor S so as not to be used, and physically blocking the detection waves of the sensor S.

In the overhead transport vehicle 1, the transport vehicle controller 9 controls, in a case of transferring the article 100 from the load port 210 to the gripping unit 8, controls the rotating unit 7 to make the article 100 gripped in a specified orientation with respect to the gripping unit 8. In this case, the overhead transport vehicle 1 can always grip the article 100 in a constant direction, which facilitates adjustment of subsequent rotations.

As described above, the embodiment according to the present invention has been described, but an aspect of the present invention is not limited to the above-described embodiment, and various modifications can be made within the scope not departing from the gist of the present invention.

In the above embodiment, the article 100 is targeted as an article, but the article is not particularly limited, and may be various articles as far as they are items transported by the overhead transport vehicle 1. In the above embodiment, the transport vehicle controller 9 is included as a control section, but instead, one or more controllers other than the transport vehicle controller 9 may be included as the control section. In the above embodiment, the number and the position of the sensors S are not limited. At least two or more sensor S are installed in the overhead transport vehicle 1 and their installation positions may be various positions.

In the above embodiment, the first position with the least necessity of rotating the gripping section in terms of the track layout is the initial position, but this is not limited thereto. The second position or the third position may be the initial position, or reasonably may be a position other than the initial position.

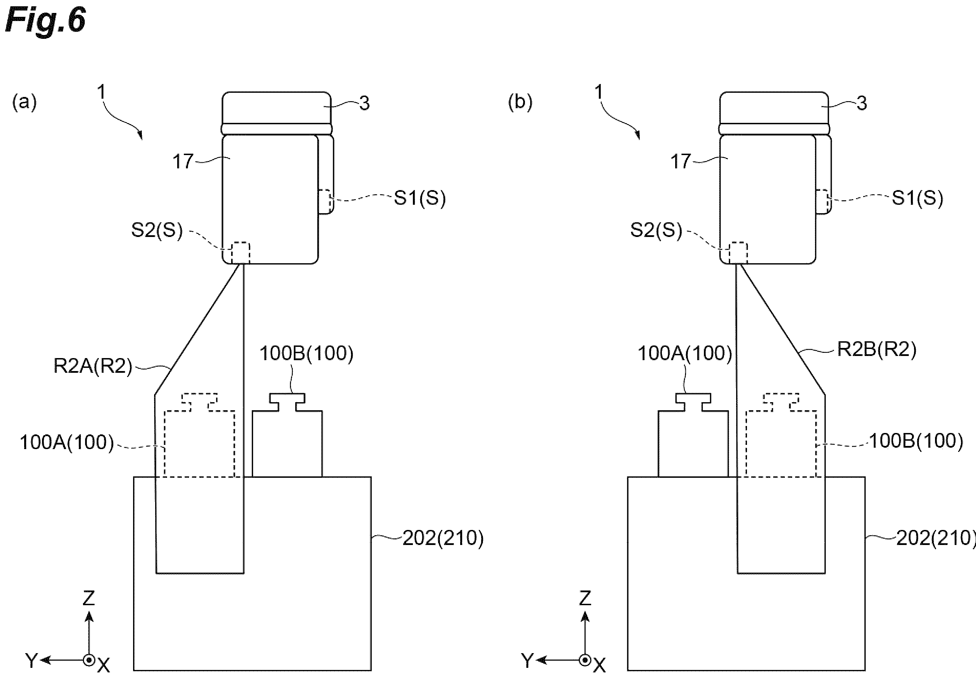

In the above embodiment, the detection ranges R1 to R3 of the first to the third sensors S1 to S3 are not particularly limited. The first to the third sensors S1 to S3 may be sensors whose detection ranges R1 to R3 can be changed (switched) as needed. For example, as illustrated in FIG. 6(a), the second sensor S2, in a case where the articles 100A, 100B are placed side by side in the Y direction at the second load port 202, may switch the detection range R2A corresponding to the article 100A as the detection range R2. The detection range R2A is a range where the article 100A is included and the article 100B is not included (that is, that covers only the article 100A) as viewed from the front side of the second load port 202. In addition, as illustrated in FIG. 6(b), for example, the second sensor S2, in a case where the articles 100A, 100B are placed side by side in the Y direction at the second load port 202, may switch the detection range R2B corresponding to the article 100B as the detection range R2. The detection range R2B is the range where the article 100B is included and the article 100A is not included (that is, covers only the article 100B) as viewed from the front side of the second load port 202. Note that the second sensor S2 may reasonably have a detection range corresponding to both the articles 100A and 100B (a range where the articles 100A, 100B are included and that covers the articles 100A, 100B).

In the above embodiment, the rotating unit 7 rotates the gripping unit 8 to switch the rotation position of the gripping unit 8 between the first to the third positions, but the rotation of the gripping unit 8 by the rotating unit 7 is not limited. For example, in the above embodiment, the rotating unit 7 may rotate the gripping unit 8 so that the rotation position of the gripping unit 8 around the central axis is in any desired position. In addition, for example, in the above embodiment, the rotating unit 7 may rotate the gripping unit 8 so that the rotation position of the gripping unit 8 changes between at least two of the first position to a fifth position. The fourth position is a rotation position that differs by +180° from the first position, and the fifth position is a rotation position that differs by -180° from the first position. In a case where the rotation position of the gripping unit 8 includes at least one of the fourth and the fifth rotation positions, another sensor S may be further installed on the other side of the advance direction (sideway opposite the first sensor S1) in the lifting drive section 14 of the overhead transport vehicle 1.

In the above embodiment, the port information is obtained from the map data, but the port information may be obtained, for example, by receiving from a host controller (not illustrated). In the above embodiment, the layout of the track 20 is not limited to the example illustrated in FIG. 2, and various layouts can be employed.

Various materials and shapes can be applied to each configuration in the above embodiment, without being limited to the materials and shapes described above. Each configuration in the above embodiment or the modification can be arbitrarily applied to each configuration in other embodiments or modifications. Some of each configuration in the above embodiment or the modification can be omitted as appropriate to the extent that it does not depart from the gist of one aspect of the invention.

The following describes the components of one aspect of the present invention.

### <Invention 1>

An overhead transport vehicle configured to travel along a track and transport an article, the overhead transport vehicle including:
a transfer section configured to transfer the article to and from a load port included in equipment;
a plurality of sensors configured to emit detection waves downwardly during transferring of the article by the transfer section to detect presence or absence of an obstacle, the sensors having different detection ranges from each other; and
a control section configured to control the overhead transport vehicle, in which
the transfer section includes a gripping section configured to grip the article, a rotating section configured to rotate the gripping section around a rotation axis along a vertical direction as a basic axis, and a lifting section configured to raise and lower the gripping section, and
the control section,
during transferring of the article by the transfer section, controls the rotating section in accordance with a direction of accessing onto the load port such that the article is transferred in a specified direction and does not perform detection processing of one or more sensors, among the plurality of sensors, having detection ranges in which the equipment is included according to a positional relationship with respect to the load port.

### <Invention 2>

The overhead transport vehicle according to Invention 1, in which
the lifting section raises and lowers the rotating section together with the gripping section, and
the rotating section rotates only the gripping section.

### <Invention 3>

The overhead transport vehicle according to Invention 1 or 2, in which the rotating section rotates the gripping section so that a rotation position around the rotation axis of the gripping section switches between at least a first position, a second position that differs by +90° from the first position, and a third position that differs by -90° from the first position.

### <Invention 4>

The overhead transport vehicle according to any one of Inventions 1 to 3, in which the sensor has a detection range in at least three directions in plan view including forwards, backwards, and in one sideways direction of an advance direction of the overhead transport vehicle.

### <Invention 5>

The overhead transport vehicle according to any one of Inventions 1 to 4, in which
the transfer section includes an adjusting section configured to rotate the lifting section together with the gripping section and the rotating section around the rotation axis as a basic axis and to adjust the rotation position around the rotation axis of the gripping section, the rotating section, and the lifting section.

### <Invention 6>

The overhead transport vehicle according to any one of Inventions 1 to 5, in which the control section
pre-stores sensor-for-use information in which a rotation position around the rotation axis of the gripping section is associated with one or more sensors to be used among the plurality of sensors, and
determines, during transferring of the article by the transfer section, one or more sensors to be disabled based on the sensor-for-use information and the rotation position around the rotation axis of the gripping section.

### <Invention 7>

The overhead transport vehicle according to any one of Inventions 1 to 6, in which the track includes a transit track passing over the equipment and passing over the load port included in the equipment along a front-rear direction of the load port.

### <Invention 8>

The overhead transport vehicle according to any one of Inventions 1 to 7, in which the control section performs control not to emit a detection wave when not performing the detection processing of one or more sensors, among the plurality of sensors, having the detection ranges in which the equipment is included.

### <Invention 9>

The overhead transport vehicle according to any one of Inventions 1 to 8, in which the control section, in a case of transferring the article from the load port to the gripping section, controls the rotating section to bring the article gripped in a specified orientation with respect to the gripping section.

### Reference Signs List

- 1: Overhead transport vehicle
- 4: Lateral unit (transfer section)
- 5: Theta unit (transfer section, adjusting section)
- 6: Lifting drive unit (transfer section, lifting section)
- 7: Rotating unit (transfer section, rotating section)
- 8: Gripping unit (transfer section, gripping section)
- 9: Transport vehicle controller (control section)
- 20: Track
- 100: Article
- 200: Processing equipment (equipment)
- 201: First load port (load port)
- 202: Second load port (load port)
- 203: Third load port (load port)
- 210: Load port
- S: Sensor
- S1: First sensor (sensor)
- S2: Second sensor
- S3: Third sensor

## Claims

1. An overhead transport vehicle configured to travel along a track and transport an article, the overhead transport vehicle including:
a transfer section configured to transfer the article to and from a load port included in equipment;
a plurality of sensors configured to emit detection waves downwardly during transferring of the article by the transfer section to detect presence or absence of an obstacle, the sensors having different detection ranges from each other; and
a control section configured to control the overhead transport vehicle, in which
the transfer section includes a gripping section configured to grip the article, a rotating section configured to rotate the gripping section around a rotation axis along a vertical direction as a basic axis, and a lifting section configured to raise and lower the gripping section, and
the control section,
during transferring of the article by the transfer section, controls the rotating section in accordance with a direction of accessing onto the load port such that the article is transferred in a specified direction and does not perform detection processing of one or more sensors, among the plurality of sensors, having detection ranges in which the equipment is included according to a positional relationship with respect to the load port.

2. The overhead transport vehicle according to claim 1, wherein
the lifting section raises and lowers the rotating section together with the gripping section, and
the rotating section rotates only the gripping section.

3. The overhead transport vehicle according to claim 1 or 2, wherein the rotating section rotates the gripping section so that a rotation position around the rotation axis of the gripping section switches between at least a first position, a second position that differs by +90° from the first position, and a third position that differs by -90° from the first position.

4. The overhead transport vehicle according to claim 1 or 2, wherein the sensor has a detection range in at least three directions in plan view including forwards, backwards, and in one sideways direction of an advance direction of the overhead transport vehicle.

5. The overhead transport vehicle according to claim 1 or 2, wherein
the transfer section includes an adjusting section configured to rotate the lifting section together with the gripping section and the rotating section around the rotation axis as a basic axis and to adjust a rotation position around the rotation axis of the gripping section, the rotating section, and the lifting section.

6. The overhead transport vehicle according to claim 1 or 2, wherein the control section
pre-stores sensor-for-use information in which a rotation position around the rotation axis of the gripping section is associated with one or more sensors to be used among the plurality of sensors, and
determines, during transferring of the article by the transfer section, one or more sensors to be disabled based on the sensor-for-use information and the rotation position around the rotation axis of the gripping section.

7. The overhead transport vehicle according to claim 1 or 2, wherein the track includes a transit track passing over the equipment and passing over the load port included in the equipment along a front-rear direction of the load port.

8. The overhead transport vehicle according to claim 1 or 2, wherein the control section performs control not to emit a detection wave when not performing the detection processing of one or more sensors, among the plurality of sensors, having the detection ranges in which the equipment is included.

9. The overhead transport vehicle according to claim 1 or 2, wherein the control section, in a case of transferring the article from the load port to the gripping section, controls the rotating section to bring the article gripped in a specified orientation with respect to the gripping section.
